(19) Europäisches Patentamt
European Patent Office
Office européen des brevets

(11) **EP 4 665 118 A1**

(12) **EUROPEAN PATENT APPLICATION**
published in accordance with Art. 153(4) EPC

(43) Date of publication:
**17.12.2025 Bulletin 2025/51**

(51) International Patent Classification (IPC):
$H10F\ 77/20^{(2025.01)}$       $H10F\ 71/00^{(2025.01)}$
$H10F\ 77/30^{(2025.01)}$

(21) Application number: **24922683.8**

(22) Date of filing: **16.08.2024**

(86) International application number:
**PCT/CN2024/112899**

(87) International publication number:
**WO 2025/208771 (09.10.2025 Gazette 2025/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **02.04.2024 CN 202410389939**

(71) Applicant: **Zhejiang Aiko Solar Energy
Technology Co., Ltd.
Yiwu, Jinhua Zhejiang 322000 (CN)**

(72) Inventors:
• **LIU, Ruimin**
  **Jinhua, Zhejiang 322000 (CN)**
• **WANG, Yongqian**
  **Jinhua, Zhejiang 322000 (CN)**
• **LIU, Shengpu**
  **Jinhua, Zhejiang 322000 (CN)**
• **CHEN, Gang**
  **Jinhua, Zhejiang 322000 (CN)**

(74) Representative: **EP&C
P.O. Box 3241
2280 GE Rijswijk (NL)**

(54) **SOLAR CELL, BATTERY MODULE, AND PHOTOVOLTAIC SYSTEM**

(57)    The present disclosure relates to the technical field of solar cells. Provided are a solar cell, a cell assembly, and a photovoltaic system. The solar cell includes a silicon wafer, a first doped layer, and a second doped layer. The second doped layer is in a combined contact with the first doped layer in a preset position to form a leakage combined contact structure; and in a case that reverse voltage applied to two ends of the solar cell is 17 V or less than 17 V, a leakage current per unit length of the leakage combined contact structure is greater than Impp/S/N. Impp is a maximum power point current of the solar cell, S is an area of the solar cell, N is a length of the leakage combined contact structure per unit area in the solar cell, and N is less than or equal to 4.32 cm/cm$^2$. Therefore, hot spot risks may be reduced while ensuring that the conversion efficiency of the solar cell is not lost too much, and meanwhile, defect control requirements of the solar cell may also be reduced or even eliminated, thereby improving the manufacturing capability of the solar cell.

Fig. 3

EP 4 665 118 A1

## Description

### Technical Field

The present disclosure relates to the technical field of solar cells, and in particular, to a solar cell, a cell assembly, and a photovoltaic system.

### Background

In the related art, a photovoltaic cell assembly is generally composed of a cell array consisting of a plurality of soar cells. In order to effectively control hot spot risks, a solar cell generally uses the design of low leakage characteristic and bypass diode, and the heating power of a leakage point is controlled by reducing leakage currents of the solar cell.

However, in such technical solution, in order to curb the risk of hot spot failure, the leakage current of the solar cell needs to be controlled at a relatively-small value, which has a high control requirement for the leakage current. However, it is an insurmountable problem for the manufacturing capability of the photovoltaic industry. During the manufacturing of the solar cells, the introduction of any defect may cause the leakage current to exceed a control value, thus leading to poor resistance to hot spot risk and low manufacturing capability.

Therefore, how to develop a new hot-spot resistant technology with higher manufacturing capability so as to improve the capability of a solar cell to resist the hot spot risks becomes a technical problem for technicians.

### Summary

The present disclosure provides a solar cell, a cell assembly, and a photovoltaic system, so as to solve the technical problem of how to improve the manufacturing capability of a solar cell and improve the capability of a solar cell to resist hot spot risks.

The present disclosure is implemented in this way. A solar cell of embodiments of the present disclosure includes: a silicon wafer, a first doped layer, and a second doped layer.

The first doped layer is disposed on the silicon wafer in a stacked manner.

The second doped layer is disposed on the silicon wafer in a stacked manner. The second doped layer has a polarity opposite to the first doped layer, the second doped layer is in a combined contact with the first doped layer in a preset position to form a leakage combined contact structure, and when reverse voltages applied to two ends of the solar cell are 17 V or less than 17 V, a leakage current per unit length of the leakage combined contact structure is greater than $Impp/S/N$, where $Impp$ is a maximum power point current of the solar cell, $S$ is an area of the solar cell, $N$ is a length of the leakage combined contact structure per unit area in the solar cell, and $N$ is less than or equal to 4.32 $cm/cm^2$.

Still further, the $N$ is less than or equal to 3.45 $cm/cm^2$.

Still further, the $N$ is less than or equal to 2.59 $cm/cm^2$.

Still further, when the reverse voltages applied to the two ends of the solar cell are 9 V, the leakage current per unit length of the leakage combined contact structure is greater than $Impp/S/N$.

Still further, when the reverse voltages applied to the two ends of the solar cell are 6 V, the leakage current per unit length of the leakage combined contact structure is greater than $Impp/S/N$.

Still further, the solar cell is a double-sided solar cell. The silicon wafer has a first surface and a second surface, which are opposite to each other; the first doped layer is disposed on the first surface in a stacked manner; the second doped layer is disposed on the second surface in a stacked manner; the second doped layer and the first doped layer form a combined contact in a preset position on an edge of the silicon wafer, so as to form the leakage combined contact structure.

Still further, the solar cell is a back-contact solar cell. The silicon wafer has a front side and a back side, which are opposite to each other; a plurality of first doped layers and a plurality of second doped layers are disposed on the back side in a stacked manner; the plurality of first doped layers and the plurality of second doped layers are alternately arranged in sequence at intervals; there is a gap region between the first doped layer and the second doped layer; in a preset position of the gap region, the first doped layer and the second doped layer are in a combined contact to form the leakage combined contact structure.

The present disclosure further provides a cell assembly. The cell assembly includes the solar cell described in any one of the above.

Still further, the cell assembly includes a plurality of cell strings. The cell string includes a plurality of solar cells in series, and a bypass diode is in parallel connection with two ends of the cell string.

Reverse bias of two ends of the solar cell shadowed are $<D*Voc*(M-1)+L$.

**The** reverse bias are voltages of the two ends of the shadowed solar cell when the solar cell is shadowed and a leakage current of the shadowed solar cell reaches a maximum power point current; and $Voc$ is an open circuit voltage of the solar cell, $M$ is the number of the solar cells in the cell string that is in parallel connection with the bypass diode, $D$ is a constant less than 1, and L is a starting voltage of the bypass diode.

Still further, the cell assembly includes a plurality of cell strings. **The** cell string includes a plurality of solar cells in series.

Reverse bias of two ends of the solar cell shadowed are <D*Voc*(P-1).

**The** reverse bias are voltages of the two ends of the shadowed solar cell when the solar cell is shadowed and a leakage current of the shadowed solar cell reaches a maximum power point current; and Voc is an open circuit voltage of the solar cell, P is the number of the solar cells that are in series connection with the shadowed solar cell, and D is a constant less than 1.

Still further, a value range of the D is 0.1-0.5.

Still further, when the solar cell is shadowed, heating power of the single leakage combined contact structure in the solar cell is less than 8.85 W.

Still further, the number S of the leakage combined contact structures in the solar cell meets the following condition.

$$S > (Impp * V_{Impp})/8.85 \text{ W}$$

Impp is a maximum power point current of the solar cell, $V_{Impp}$ is reverse bias of two ends of the shadowed solar cell when the solar cell is shadowed and a leakage current of the shadowed solar cell reaches a maximum power point current, and S is a positive integer.

Still further, when the solar cell is shadowed, in the solar cell, and within any 4 cm*4 cm square range, the leakage current $I_{leakage}$ of the solar cell meets the following condition.

$$I_{leakage} < 8.85 \text{ W}/V_{Impp}$$

$I_{leakage}$ is a sum of leakage currents of all the leakage combined contact structures within the 4 cm*4 cm square range, and $V_{Impp}$ is reverse bias of two ends of the shadowed solar cell when the solar cell is shadowed and a leakage current of the shadowed solar cell reaches a maximum power point current.

Still further, when the solar cell is shadowed, in the solar cell, and within any 4 cm*4 cm square range, the leakage current $I_{leakage}$ of the solar cell meets the following condition.

$$I_{leakage} < 4.54 \text{ W}/V_{Impp}$$

$I_{leakage}$ is the sum of leakage currents of all the leakage combined contact structures within the square range, and $V_{Impp}$ is the reverse bias of the two ends of the shadowed solar cell when the solar cell is shadowed and the leakage current of the shadowed solar cell reaches the maximum power point current.

Still further, when the solar cell is shadowed, in the solar cell, and within any 4 cm*4 cm square range, the leakage current $I_{leakage}$ of the solar cell meets the following condition.

$$I_{leakage} < 2.26 \text{ W}/V_{Impp}$$

$I_{leakage}$ is the sum of leakage currents of all the leakage combined contact structures within the square range, and $V_{Impp}$ is the reverse bias of the two ends of the shadowed solar cell when the solar cell is shadowed and the leakage current of the shadowed solar cell reaches the maximum power point current.

Still further, in the solar cell, spacing between two adjacent leakage combined contact structures is greater than or equal to 4 cm.

The present disclosure further provides a photovoltaic system. The photovoltaic system includes the cell assembly described above.

In the solar cell, cell assembly, and photovoltaic system of the embodiments of the present disclosure, by introducing the leakage combined contact structure formed by the two doped layers with different polarities in the preset position, and rationally designing the leakage current per unit length of the leakage combined contact structure, the leakage capability of the solar cell may be improved, such that the leakage combined contact structure has a high reverse leakage characteristic. In this way, with the improvement of the leakage capability, on an assembly end, when the solar cell is shadowed, and when the leakage current of the solar cell reaches the maximum power point current, the voltages on the two ends of the shadowed solar cell decrease, and the heating power of the solar cell reduces, thereby achieving the purpose of controlling the hot spot risks. Meanwhile, by using the technical solutions of the present disclosure, and by, for example, particularly introducing the leakage combined contact structure in the preset position, the leakage combined contact structure has a protection effect on hot spots caused by the defects of the silicon wafer itself, and defect control requirements may be reduced or even eliminated, such that the manufacturing capability of the solar cell is improved while reducing the hot spot risks caused by the defects. Furthermore, in the present disclosure, by rationally designing the length of the leakage combined contact structure per unit area, the efficiency may be prevented from being lost too much, thereby ensuring the conversion efficiency of the solar cell.

Additional aspects and advantages of the present disclosure will be partially set forth in the following description, and in part will be apparent from the following description, or may be learned by practice of the present disclosure.

## Brief Description of the Drawings

Fig. 1 is a schematic module diagram of a photovoltaic system according to embodiments of the present disclosure.

Fig. 2 is a schematic module diagram of a cell assembly according to embodiments of the present disclosure.

Fig. 3 is a schematic diagram of a planar structure of a back-contact solar cell according to embodiments of the present disclosure.

Fig. 4 is a schematic cross-sectional view of the back-contact solar cell along a line IV-IV in Fig. 3.

Fig. 5 is another schematic cross-sectional view of the back-contact solar cell along a line IV-IV in Fig. 3.

Fig. 6 is still another schematic cross-sectional view of the back-contact solar cell along a line IV-IV in Fig. 3.

Fig. 7 is a schematic diagram of a planar structure of a double-sided solar cell according to embodiments of the present disclosure.

Fig. 8 is a schematic cross-sectional view of the double-sided solar cell along a line VIII-VIII in Fig. 7.

Fig. 9 is another schematic cross-sectional view of the double-sided solar cell along a line VIII-VIII in Fig. 7.

Fig. 10 is a relationship diagram of a hot spot temperature of a solar cell and carried heating power.

Fig. 11 is an equivalent circuit diagram of a cell assembly in the related art.

In the drawings:
1000. Photovoltaic system; 200. Cell assembly; 100. Solar cell; 101. Preset position; 10. Silicon wafer; 11. First surface; 12. Second surface; 13. Front side; 14. Back side; 20. First doped layer; 30. Second doped layer; 40. Leakage combined contact structure; 50. Gap region; 60. First dielectric layer; 70. Second dielectric layer; 80. Third dielectric layer; 90. Fourth dielectric layer; 110. Fifth dielectric layer; and 120. Sixth dielectric layer.

## Detailed Description of the Embodiments

To make the objectives, technical solutions and advantages of the present disclosure clearer, the present disclosure is further described in detail. Examples of the embodiments are shown in the accompanying drawings, where the same or similar reference numerals throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it should be understood that orientation or position relationships indicated by the terms such as "length", "width", "top", "bottom", "horizontal", "vertical", and the like are based on orientation or position relationships shown in the accompanying drawings, and are used only for ease and brevity of illustration and description of the present disclosure, rather than indicating or implying that the mentioned apparatus or element needs to have a particular orientation or needs to be constructed and operated in a particular orientation. Therefore, such terms should not be construed as a limitation on the present disclosure.

In addition, the terms "first" and "second" are used for descriptive purposes only and are not to be construed as indicating or implying relative importance or implicitly specifying the number of technical features indicated. Thus, features defined by "first" and "second" may explicitly or implicitly include one or more of the features. In the description of the present disclosure, the meaning of "a plurality of" is two or more, unless explicitly and specifically defined otherwise.

In the description of the present disclosure, it is to be noted that, unless otherwise clearly specified and limited, the terms "mounted", "connected" and "connect" should be interpreted broadly. For example, the term "connect" may be fixed connection, detachable connection or integral construction. As an alternative, the term "connect" may be mechanical connection, or electrical connection, or mutual communication. As an alternative, the term "connect" may be direct connection, or indirect connection through a medium, or communication in two elements or the interaction between two components. For those of ordinary skill in the art, specific meanings of the foregoing terms in the present disclosure may be understood based on specific situations.

In the present disclosure, unless otherwise explicitly specified and defined, a first feature being "over" or "below" a second feature may mean that the first feature and the second feature are in direct contact, or the first feature and the second feature are not in direct contact but are in contact through another feature therebetween. Moreover, the first feature being "over", "above", and "on" the second feature includes that the first feature is directly above or obliquely above the second feature, or merely means that the first feature has a larger horizontal height than the second feature. The first feature being "beneath", "under" and "below" the second feature including the first feature being right under or at an inclined lower portion of the second feature, or simply indicating that the horizontal height of the first feature is less than that of the second feature.

The following disclosure provides many different embodiments or examples for achieving different structures of the present disclosure. In order to simplify the present disclosure of the present disclosure, components and settings of specific examples are described below. Certainly, they are merely examples, and are not intended to limit the present disclosure. In addition, the present disclosure may repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those persons skilled in the field may be aware of the application of other processes and/or usage scenarios of other materials.

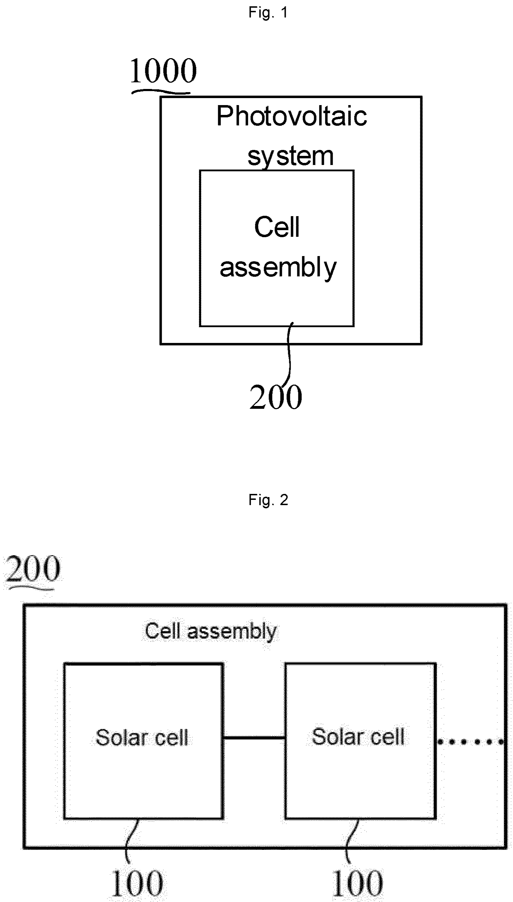

Referring to Fig. 1 to Fig. 2, a photovoltaic system 1000 in the embodiments of the present disclosure may include a cell assembly 200 in the embodiments of the present disclosure. The cell assembly 200 in the embodiments of the present disclosure may include a plurality of solar cells 100 in the embodiments of the present disclosure. In the embodiments of the present disclosure, the plurality of solar cells 100 in the cell assembly 200 may be connected in series together to form a plurality of cell strings. Each cell string may be connected in series, parallel, or a combination of series and parallel, so as to realize the convergence output of currents. For example, a connection between the solar cells may be realized by soldering ribbons, and a connection between the cell strings may be realized through bus bars. In some embodiments, the cell strings may constitute a solar cell array, and then the cell assembly 200 is formed by packaging a front plate, a front adhesive film, a rear adhesive film, and a back plate together.

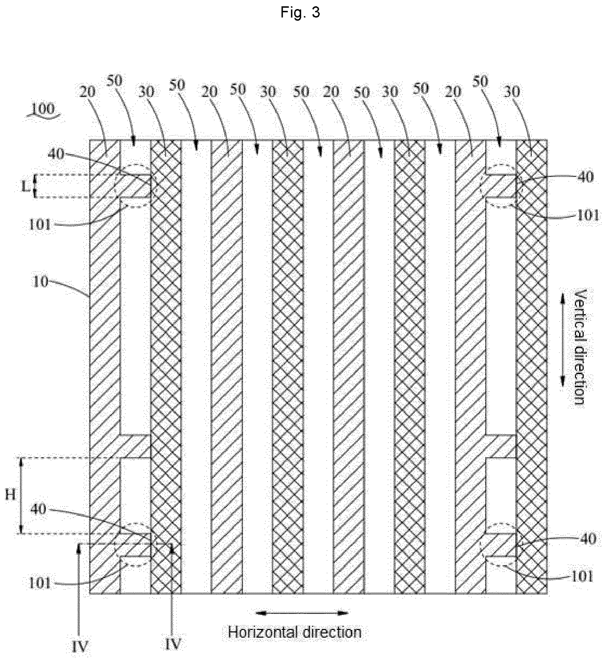

Referring to Fig. 3 to Fig. 8, the solar cell 100 in the embodiments of the present disclosure may include a silicon wafer 10, a first doped layer 20, and a second doped layer 30. The silicon wafer 10 may be a P-type silicon wafer, or may also be an N-type silicon wafer, which is not specifically limited herein. The first doped layer 20 is disposed on the silicon wafer 10 in a stacked manner, the second doped layer 30 is also disposed on the silicon wafer 10 in a stacked manner, and the second doped layer 30 has a polarity opposite to the first doped layer 20. Specifically, in the embodiments of the present disclosure, the first doped layer 20 may be an N-type doped layer, and the second doped layer 30 may be a P-type doped layer, or the first doped layer 20 is the P-type doped layer, and the second doped layer 30 is the P-type doped layer. Details are not limited herein, as long as the polarities of the first doped layer and second doped layer are opposite.

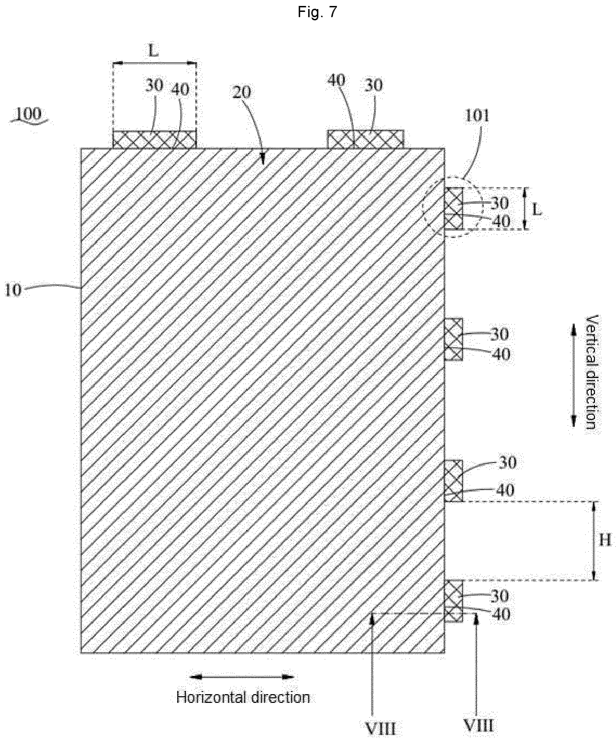

As shown in Fig. 3 and Fig. 7, in the present disclosure, the second doped layer 30 of the solar cell 100 is in a combined contact with the first doped layer 20 in a preset position 101 to form a leakage combined contact structure 40, and when reverse voltages applied to two ends of the solar cell 100 are 17 V or less than 17 V, a leakage current per unit length of the leakage combined contact structure 40 is greater than Impp/S/N.

Impp is a maximum power point current of the solar cell 100, S is an area (i.e., areas of a light-receiving surface and backlight surface of the silicon wafer 10) of the solar cell 100, N is a length of the leakage combined contact structure 40 per unit area in the solar cell 100, and N is less than or equal to 4.32 cm/cm$^2$.

It is to be noted that, the maximum power point current of the solar cell 100 is a current when the solar cell is at maximum power under a standard test condition, where the standard test condition is a general and known standard test technology in the technical field of solar cells, and is not described herein again.

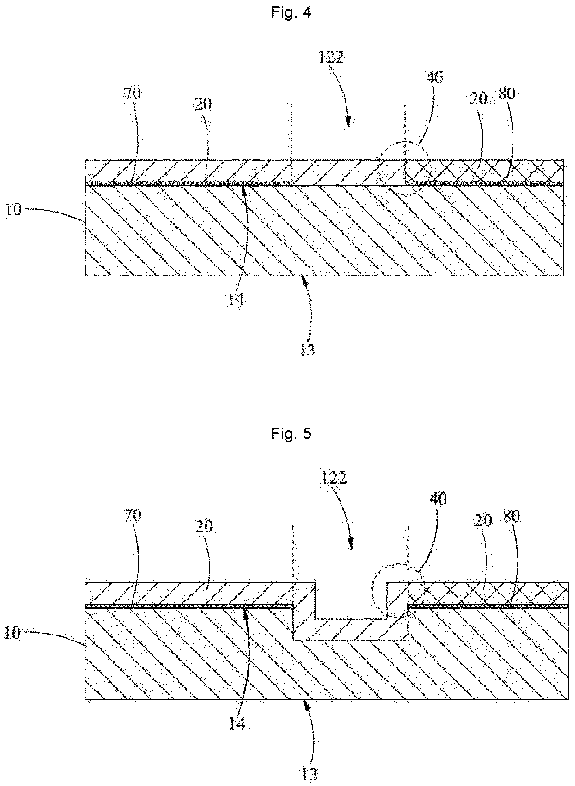

Referring to Fig. 3 and Fig. 4, in some embodiments, the solar cell 100 may be a back-contact solar cell. In this case, the silicon wafer 10 may include a front side 13 and a back side 14, which are opposite to each other; a plurality of first doped layers 20 and a plurality of second doped layers 30 are disposed on the back side 14 in a stacked manner; the plurality of first doped layers 20 and the plurality of second doped layers 30 are alternately arranged in sequence at intervals; there is a gap region 50 between the first doped layer 20 and the second doped layer 30; in a preset position 101 of the gap region 50, the first doped layer 20 and the second doped layer 30 are in a combined contact to form the leakage combined contact structure 40. Specifically, as shown in Fig. 3, in the back-contact solar cell, the plurality of first doped layers 20 and the plurality of second doped layers 30 may successively alternately arranged at intervals in a horizontal direction and all extend in a vertical direction, and the gap region is between the first doped layer 20 and the second doped layer 30, which are adjacent to each other.

That is to say, as shown in Fig. 4, in the preset position 101, a portion of the first doped layer 20 may extend to the gap region 50 to form a combined contact with the second doped layer 30, so as to form the leakage combined contact structure 40. It may be understood that, Fig. 4 only shows an implementation. In other embodiments, in the preset position 101, a portion of the second doped layer 30 may extend to the gap region 50 to form a combined contact with the first doped layer 20, so as to form the leakage combined contact structure 40. Furthermore, in some embodiments, in the preset position 101, the first doped layer 20 and the second doped layer 30 extend along the gap region 50, such that the first doped layer and the second doped layer are in a combined contact in the gap region 50 to form the leakage combined contact structure 40, which is not specifically limited herein.

As shown in Fig. 5, in some embodiments, in the back-contact solar cell, the back surface 14 may be provided with a plurality of grooves at interval. The first doped layer 20 and the second doped layer 30 may be disposed on a surface with no grooves, and the grooves correspond to the gap regions 50. Two sides of the groove respectively are the first doped layer 20 and the second doped layer 30, and the first doped layer 20 and the second doped layer 30 are isolated by grooves. Definitely, it may be understood that, in some embodiments, a wider width of the groove may also be designed. In this case, the first doped layer 20 may be disposed on the surface with no grooves, and the second doped layer 30 may be disposed in the groove. In this way, the groove between the second doped layer 30 and the first doped layer 20 is the gap region 50 herein.

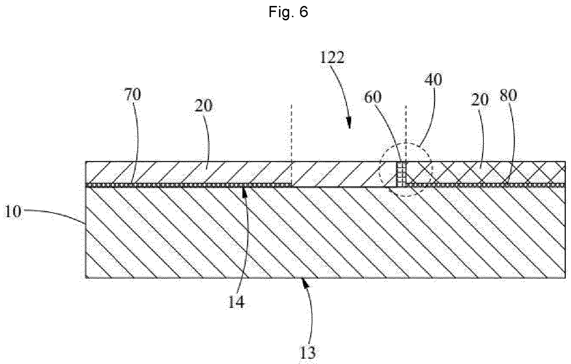

It is to be noted that, in the present disclosure, "the first doped layer 20 and the second doped layer 30 being in a combined contact to form the leakage combined contact structure 40" means that in the preset position 101, the first doped layer 20 and the second doped layer 30 are not isolated from each other, and are combinedd in the preset position 101. The first doped layer and the second doped layer may be in a direct contact to form the combined contact, or may also achieve the combined contact through a dielectric layer, so as to form a leakage point location (i.e., the leakage combined contact structure 40), preferably achieve the combined contact through the dielectric layer. For example, as shown in Fig. 6, in some embodiments, the first doped layer 20 and the second doped layer 30 forming the combined contact may be that there is a first dielectric layer 60 between the first doped layer and the second doped layer. The first dielectric layer 60 may be a film layer such as a tunneling oxide layer, for example, a film layer such as a silicon oxide film layer having a passivation function. At least partial region of the first dielectric layer 60 has a tunneling function so as to realize the combined contact between the first doped layer 20 and the second doped layer 30. In this way, the first dielectric layer 60 may well passivate the surface on which the first doped layer and the second doped layer are in contact while realizing the combined contact with both.

Furthermore, referring to Fig. 4 to Fig. 6, in some embodiments, the back-contact solar cell may further include a second dielectric layer 70 disposed between the first doped layer 20 and the back side 14 of the silicon wafer 10 in a stacked manner and a third dielectric layer 80 disposed between the second doped layer 30 and the back side 14 of the silicon wafer 10 in a stacked manner. The second dielectric layer 70 and the third dielectric layer 80 both may be tunneling layers, for example, a film layer having passivation and tunneling functions such as a silicon oxide tunneling layer, and a specific type may be selected according to actual situations, and thus is not specifically limited herein. That is to say, in the entire solar cell 100, there is a second dielectric layer 70 as long as there is a position for the first doped layer 20, and there is a third dielectric layer 80 as long as there is a position for the second doped layer 30. That is, if the first doped layer 20 extends to the gap region 50, there is also a second dielectric layer 70 (not shown in the figure) at a lower part of the portion of the first doped layer 20 extending to the gap region 50; and if the second doped layer 30 extends to the gap region 50, there is also a third dielectric layer 80 (not shown in the figure) at a lower part of the portion of the second doped layer 30 extending to the gap region 50.

As shown in Fig. 3, it is easily understood that, in the back-contact solar cell, a length L of the leakage combined contact structure 40 refers to a length in a length direction (i.e., a vertical direction in Fig. 3, that is, an extending direction of the first doped layer 20 and the second doped layer 30) of the leakage combined contact structure 40 in the gap region 50, that is, a length of the leakage combined contact structure 40 in the vertical direction in Fig. 3, that is, a length of the surface on which the first doped layer 20 and the second doped layer 30 are in the combined contact in the vertical direction. "The unit length of the leakage combined contact structure 40" refers to the length of the leakage combined contact structure per unit area, that is, a ratio of a total length of all the leakage combined contact structures 40 to an area (i.e., a light-receiving area of the solar cell 100) of the front side 13 or back side 14 of the silicon wafer 10. "The area of the solar cell 100" refers to an orthographic projection area of the solar cell 100 in a thickness direction, that is, areas of a light-receiving surface and backlight surface of the solar cell 100.

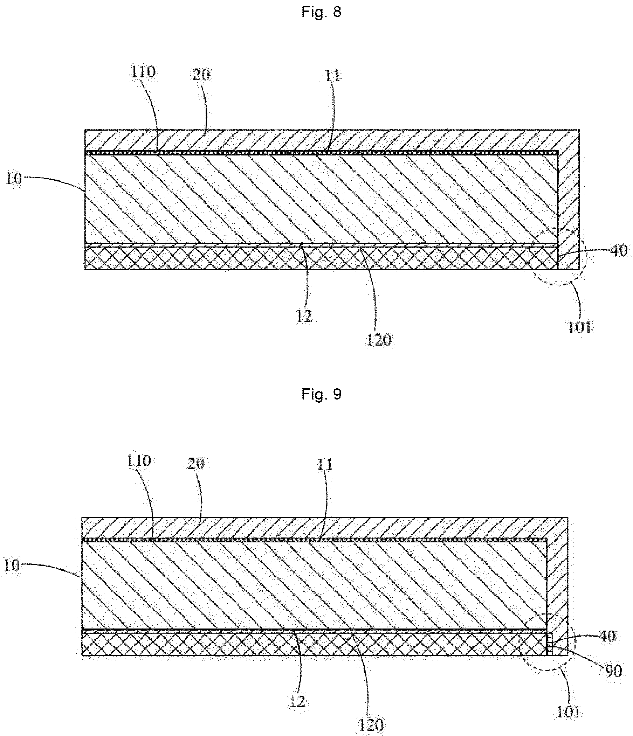

Referring to Fig. 7 and Fig. 8, in some embodiments, the solar cell 100 may also be a double-sided solar cell, such as a PERC solar cell, a Topcon solar cell, etc.

As shown in Fig. 8, in this case, the silicon wafer 10 has a first surface 11 and a second surface 12, which are opposite to each other; the first doped layer 20 is disposed on the first surface 11 in stacked manner; the second doped layer 30 is disposed on the second surface 12 in stacked manner; the second doped layer 30 and the first doped layer 20 form a combined contact in a preset position 101 on an edge of the silicon wafer 10, so as to form the leakage combined contact structure 40.

Specifically, as shown in Fig. 8, in the double-sided solar cell, the first doped layer 20 and the second doped layer 30 are respectively disposed on the two opposite surfaces of the silicon wafer 10, such that the first doped layer 20 and the second doped layer 30 may form the combined contact in the preset position 101 on the edge of the silicon wafer 10, so as to form the leakage combined contact structure 40.

As shown in Fig. 8, in this embodiment, while the first doped layer 20 is disposed on the first surface 11 in a stacked manner, in the preset position 101 on the edge of the silicon wafer 10, the first doped layer 20 may extend to the second surface 12 along the edge of the silicon wafer 10 to form the combined contact with the second doped layer 30 on an edge of the second surface 12, so as to form the leakage combined contact structure 40.

Definitely, it may be understood that, in some embodiments, while the second doped layer 30 is disposed on the second surface 12 in a stacked manner, in the preset position 101 on the edge of the silicon wafer 10, the second doped layer 30 may also extend to the first surface 11 along the edge of the silicon wafer 10 to form the combined contact with the first doped layer 20 on an edge of the first surface 11. Furthermore, in some other embodiments, the first doped layer 20 and the second doped layer 30 may also extend oppositely in the preset position 101 on the edge of the silicon wafer 10, so as to form the combined contact on side surfaces (e.g., the plane connecting the first surface 11 and the second surface 12) of the silicon wafer 10, which is not specifically limited herein, as long as the first doped layer and the second doped layer can form the combined contact in partial region of the edge of the silicon wafer 10.

Likewise, as shown in Fig. 9, in the double-sided solar cell, the combined contact formed by the first doped layer 20 and the second doped layer 30 may be a direct contact between the first doped layer and the second doped layer, or a fourth dielectric layer 90 may also be disposed between the first doped layer and the second doped layer. The fourth dielectric layer 90 may have the same material and property as the first dielectric layer 60, and thus is not described herein again.

It is to be noted that, the double-sided solar cell shown in Fig. 8 and Fig. 9 is a double-sided Topcon solar cell. In such cell, there is a fifth dielectric layer 110 between the first doped layer 20 and the first surface 11, there is a sixth dielectric layer 120 between the second doped layer 30 and the second surface 12, and the fifth dielectric layer 110 and the sixth dielectric layer 120 both may be tunneling layers, such as a film layer having passivation and tunneling functions such as a silicon oxide tunneling layer, and a specific type may be selected according to actual situations, and thus is not specifically limited herein.

Likewise, as shown in Fig. 7, it is easily understood that, in the double-sided solar cell, a length L of the leakage combined contact structure 40 refers to a length of an orthographic projection of the leakage combined contact structure 40 on the edge of the silicon wafer 10 in the length direction, namely, a length of the leakage combined contact structure 40 in a vertical direction or a horizontal direction in Fig. 7. When the leakage combined contact structure 40 is located on the edges of left and right sides of the silicon wafer 10, the length L is the length in the vertical direction, and when the leakage combined contact structure 40 is located on the edges of upper and lower sides of the silicon wafer, the length L is the length in the horizontal direction, that is, a length of the surface where the first doped layer 20 and the second doped layer 30 are in the combined contact in the vertical direction or horizontal direction.

"The unit length of the leakage combined contact structure 40" refers to the length of the leakage combined contact structure per unit area, that is, a ratio of a total length of all the leakage combined contact structures 40 to an area (i.e., a light-receiving area of the solar cell 100) of the first surface 11 or second surface 12 of the silicon wafer 10. **It** may be understood that, the first surface 11 and second surface 12 here are actually equivalent to the front side 13 and back side 14.

**To** sum up, in the solar cell 100, cell assembly 200, and photovoltaic system 1000 in the embodiments of the present disclosure, the first doped layer 20 and the second doped layer 30 in the solar cell 100 are in the combined contact in the preset position 101, so as to form the leakage combined contact structure 40, and when reverse voltages applied to two ends of the solar cell 100 are 17 V or less than 17 V, a leakage current per unit length of the leakage combined contact structure 40 is greater than Impp/S/N, where Impp is a maximum power point current of the solar cell 100, S is an area of the solar cell 100, N is a length of the leakage combined contact structure 40 per unit area in the solar cell 100, and N is less than or equal to 4.32 cm/cm$^2$.

Therefore, by introducing the leakage combined contact structure 40 formed by the two doped layers with different polarities in the preset position 101, and rationally designing the leakage current per unit length of the leakage combined contact structure 40, the leakage capability of the solar cell 100 may be improved, such that the leakage combined contact structure 40 has a high reverse leakage characteristic. In this way, with the improvement of the leakage capability, on an assembly end, when the solar cell 100 is shadowed, and when the leakage current of the solar cell 100 reaches the maximum power point current (Impp), the voltages on the two ends of the shadowed solar cell 100 decrease (the voltage is less than a sum of voltages of other unobstructed solar cells serially connected to the solar cell), and the heating power of the solar cell 100 reduces, thereby achieving the purpose of controlling the hot spot risks. Meanwhile, by using the technical solutions of the present disclosure, for example, particularly introducing the leakage combined contact structure 40 in the preset position 101, the leakage combined contact structure has a protection effect (i.e., may reduce a heating amount caused by defects) on hot spots caused by the defects of the silicon wafer 10 itself, and defect control requirements may be reduced or even eliminated, such that the manufacturing capability of the solar cell 100 is improved while reducing the hot spot risks caused by the defects. Furthermore, in the present disclosure, by rationally designing the length of the leakage combined contact structure 40 per unit area, the efficiency may be prevented from being lost too much, thereby ensuring the conversion efficiency of the solar cell 100.

That is to say, by using the technical solutions of the present disclosure, by rationally designing the leakage current of the leakage combined contact structure 40 per unit length and the length of the leakage combined contact structure 40 per unit area, a relationship between conversion efficiency and the control of hot spot risk may be balanced, hot spot risks may be reduced while ensuring that the conversion efficiency of the solar cell 100 is not lost too much, and meanwhile, defect control requirements of the solar cell 100 may also be reduced or even eliminated, thereby improving the manufacturing capability of the solar cell 100.

Furthermore, in the present disclosure, by introducing the leakage combined contact structure 40 in the preset position 101, in the cell string, the effect of the leakage combined contact structure is equivalent to the effect of a bypass diode. Therefore, in some embodiments, in the cell assembly 200, the bypass diode may be saved to reduce costs. Definitely, in some embodiments, in the cell assembly 200, the bypass diode may also be disposed, which is not specifically limited herein.

It is to be noted that, in the embodiments of the present disclosure, "the preset position 101" refers to a position in which the first doped layer 20 and the second doped layer 30 form the combined contact through contact. For example, in the back-contact solar cell, the preset position 101 refers to partial region or entire region of the gap region 50, preferably the partial region, and the single gap region 50 may have one or more preset positions 101. In the double-sided solar cell, the preset position 101 refers to partial region or entire region of the edge of the silicon wafer 10, preferably the partial region, and each edge of the silicon wafer 10 may have one or more preset positions 101, which is not specifically limited herein.

It may be understood that, in the solar cell 100, there may be a plurality of preset positions 101, which may be uniformly distributed or may unevenly distributed, and are not specifically limited herein.

The specific background of the present disclosure and the specific principles of the technical solutions of the present disclosure are set forth below.

In the technical field of solar cells, in previous experience, hot spot control is generally performed by means of a low leakage solution and a bypass diode superimposed. The bypass diode is used to limit voltages of two ends of a cell within a certain range, and then a leakage current of the cell is reduced by optimizing defects in the silicon wafer, thereby controlling the heating power of a leakage point caused by the defects. However, such leakage control of the solar cell is difficult to realize.

Specifically, under the packaging materials and technology of existing crystalline silicon assemblies, when a hot spot temperature is greater than 160 °C, the packaging material starts to decompose and carbonize, leading to appearance failure and fire risk.

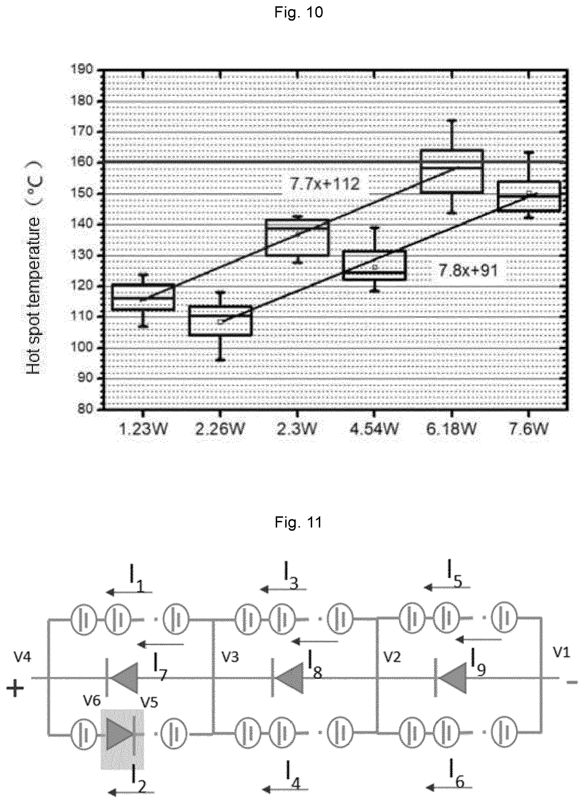

From Fig. 10, it may be learned that, Fig. 10 shows a relationship diagram of the hot spot temperature and carried heating power, with a horizontal coordinate being the heating power and a vertical coordinate being the hot spot temperature. A black curve indicates the case in which spacing between the leakage points is relatively large, and a blue curve indicates the case in which the spacing between the leakage points is relatively small. In the related art, in order to meet a hot spot requirement, hot spots are generally caused by defect points, hot spot efficiency is often caused by single point leakage, and the spacing between the leakage points is large, which may be referred to the black curve. From Fig. 10, it may be seen that, in order to meet the hot spot requirement to prevent the packaging material from decomposing and carbonizing, thereby affecting a fire, the minimum requirement for the heating power of a single point is that the heating power is at least less than 8.85 W.

Further, referring to Fig. 11, Fig. 11 shows an equivalent circuit diagram of a cell assembly using the low leakage solution in the related art. Under the most advanced production capacity of existing efficient cells such as IBC, TOPCon, HJT, etc., an open circuit voltage is generally between 0.73 and 0.755 V, and 0.74 V is taken as a representative; a current density of a short-circuit current is 38-43 mA/cm$^2$, and 42mA/cm$^2$ is taken as a representative; Vmpp and Jmpp of an assembly end cell respectively take 0.634 V and 39.5 mA/cm$^2$ as representatives; a cell size is 18.2 cm*9.1 cm; a model is 72; and the short-circuit current and an Impp current (maximum power point current) are 6.95 A and 6.54 A.

As shown in Fig. 11, when a single cell (a shaded portion at a left lower corner in Fig. 11) is shadowed, and as the shadowed cell is a low reverse leakage solution, voltages of two ends of the solar cell are increased to maximum values. Specifically, in this case, in Fig. 11, $I_1$=Isc=6.95 A, and since the cells all are low leakage solutions, currents flowing through are increased up to a Isc value, and Isc is the short-circuit current.

When leakage occurs in a defect introduction point between P/N junctions, then

I3=I4=I5=I6=6.54 A, I7=6.54 A*2-6.95 A-3 A=3.13 A, I8=I9=0 A

Assuming that a starting voltage of the bypass diode is appropriately 1 V, then V4-V3 is appropriately -1 V, then the reverse bias of the two ends of the shadowed solar cell is:

$$V6-V5=-1\ V-(0.74V*(24-1)=-18\ V$$

wherein, V3-V2=V2-V1=15.2 V

If the reverse bias is 18 V, the leakage current of the leakage point is 3 A; and when leakage occurs in the defect introduction point, the heating power is P=18 V*3 A=54 W, which is much greater than 8.85 W. Therefore, it may be seen that, conventional low leakage solutions have great potential for hot spot failures and fire hazards.

Therefore, it may be learned that, in the conventional low leakage solutions, hot spot heating power P=carried reverse bias*leakage current under carried reverse bias; and carried reverse bias=cell open circuit voltage*(the number of cells controlled by a single bypass diode-1 )+starting voltage of the bypass diode.

In conventional technical solutions, for a 72-model assembly, the number of cells controlled by the single bypass diode is 24 pcs. Therefore, for assemblies of different models and different types, for example, the starting voltage of the bypass diode is 1 V, through experimental calculation, it may be learned that, when there is a defect in the silicon wafer that introduces a leakage point, in order to meet the hot spot temperature < 160 °C, it needs to ensure that the leakage current of the cell at the carried reverse bias is < 8.85 W/(cell open circuit voltage*(the number of cells controlled by a single bypass diode-1)+1 V), so as to obtain Table 1 below. Electrical performance parameters of PERC, Topcon, HJT, and BC and the magnitude of the leakage current required to be controlled are shown in Table 1 below, and a carrying voltage in the table is reverse bias on the two ends when the solar cell is shadowed.

Table 1

| | PERC | | TOPCon | | HJT | | BC | |
|---|---|---|---|---|---|---|---|---|
| Open circuit voltage (V) | 0.695 | | 0.73 | | 0.75 | | 0.745 | |
| Assembly model | 72 | 54 | 72 | 54 | 72 | 54 | 72 | 54 |
| Number of single diode cells | 24 | 18 | 24 | 18 | 24 | 18 | 24 | 18 |
| Carrying voltage (V) | 17.0 | 12.8 | 17.8 | 13.4 | 18.3 | 13.8 | 18.1 | 13.7 |
| Leakage current control value at <8.85 W | 0.52 | 0.69 | 0.50 | 0.66 | 0.48 | 0.64 | 0.49 | 0.65 |

From Table 1, it may be seen that, by using the Topcon solar cell as an example, in the 72-model assembly, at the reverse bias of -17.8 V, the risk of hot spot failure can only be suppressed by reducing the leakage current to 0.52A, and even though in a 54-model assembly, the leakage current also needs to be reduced to 0.66 A at the reverse bias of -13.4 V. This is an insurmountable problem for the manufacturing capability of the existing photovoltaic industry. and the introduction of any defect during the production of the solar cell may cause the leakage current to exceed a control value.

At present, in order to ensure yields to cause a manufactured product to be cost-competitive, a bias of -12 V is generally used to control the leakage current, where the leakage current is controlled to be <1 A or <0.5 A. However, even though the leakage current is controlled to a certain extent during production, it actually has a high risk of hot spots. Since the magnitude of a reverse leakage current is not linearly related to the reverse bias, the leakage current when the reverse bias is 18 V is more than 4 times that of 12 V, that is to say, if on an assembly end, the reverse bias of the two ends of the shadowed solar cell are 18 V, and the leakage current reaches 2 A, and in this case, the heating power is appropriately 36 W, which exceeds more than 4 times of the control requirement of 160 °C. However, if the bias of the assembly end is directly used to control the leakage current of the solar cell, a mass requirement for the solar cell is very high, leading to low yield response and poor manufacturing capability.

Therefore, in the related art, the solution of using the low leakage solution to control the leakage current is difficult to realize, and the yield is relatively low, and thus, this is an insurmountable problem for the manufacturing capability of the existing photovoltaic industry.

Based on this, through research, the inventor of the present disclosure found that in the solar cell 100, if the solar cell 100 has a high reverse leakage characteristic (leakage capability improved), when the solar cell 100 is shadowed, only a small reverse voltage is required to achieve a large reverse leakage current. Specifically, for the solar cell 100, when the cell is shadowed, as the reverse leakage capability of the cell is improved, the reverse leakage current increases, the voltages of the two ends of the cell remain unchanged, and the heating power increases. When the reverse leakage current is increased to a maximum current value (Impp), the heating power is also increased to an extreme power value.

However, with the improvement of the reverse leakage capability of the cell, the reverse leakage current remains unchanged at the maximum current value, and the voltages of the two ends of the cell are reduced compared to a cell with lower leakage capability, causing the heating power to be reduced compared to a cell with worse reverse leakage capability. That is, as the reverse leakage capability of the cell is improved, the reverse leakage current increases, the heating power has a maximum value, and when the leakage capability is further improved, the heating power reduces, such that a hot spot effect may be suppressed. That is to say, the solar cell has the high reverse leakage characteristic by improving the leakage capability of the solar cell. When the solar cell is shadowed, only a small reverse voltage is required to cause the reverse leakage current of the solar cell to reach the maximum value (i.e., an Impp point of the solar cell 100). From another perspective, with the improvement of the leakage capability, when the reverse leakage current reaches the maximum value, the voltages of the two ends of the shadowed cell become less, thereby causing the heating power to reduce.

Furthermore, with the improvement of the leakage capability of the cell, the heating power has an extreme value, and when the reverse leakage current reaches the maximum value, the heating power is reduced with the improvement of the leakage capability. When the leakage current reaches the maximum power point current of the solar cell 100, the voltages of the two ends of the shadowed cell is independent of the number of cells in series, but is limited to the reverse current voltage characteristics of the cell itself. That is, when the solar cell is shadowed, the voltages of the two ends are not determined by the number of the solar cells in series, but is determined by the reverse current voltage characteristics of the solar cell itself. When the leakage capability is improved, the reverse voltages of the two ends become smaller. In this way,

Based on this, the inventor of the present disclosure found that the solar cell 100 may have a high reverse leakage characteristic by introducing the particular leakage combined contact structure 40 on the solar cell 100, and the purpose of controlling hot spot risk and protecting defects can be achieved. Specifically, by introducing the leakage combined contact structure 40, the reverse bias of the solar cell 100 may be reduced, such that the heating power of a heating point caused by the defects is reduced, thereby reducing the control requirement for the leakage current during production. Meanwhile, considering that the introduction of the leakage combined contact structure 40 affects the efficiency of the solar cell, an efficiency loss expected is required to be not greater than 0.5%.

Based on this, through detailed research and verification, the inventor of the present disclosure found that, in the solar cell 100, the effect of the length of the leakage combined contact structure 40 per unit area on efficiency is 0.1158%, and in the 18.2*18.2 solar cell 100, the effect on the efficiency is $3.5*10^{-4}$% every time the length of the leakage combined contact structure 40 is increased 1 cm.

Therefore, in order to control the requirement that the efficiency loss is not greater than 0.5%, through research, the inventor of the present disclosure found that, the length N of the leakage combined contact structure 40 per unit area needs to be set to be less than or equal to 4.32 cm/cm$^2$. Based on this, through research and verification, the inventor of the present disclosure found that, in order to cause the solar cell 100 to have a high reverse leakage characteristic when the efficiency effect is not greater than 0.5% so as to effectively control hot spots and improve the manufacturing capability by reducing the control of the leakage current, it at least needs to ensure that the condition that the leakage current of the leakage combined contact structure 40 per unit length is greater than Impp/S/N can be met when the reverse voltage of 17 V or less than 17 V is applied to the solar cell 100. Impp is a maximum power point current of the solar cell 100, S is an area of the solar cell 100, N is a length of the leakage combined contact structure 40 per unit area in the solar cell 100, and N is less than or equal to 4.32 cm/cm$^2$. Therefore, the technical solutions of the present disclosure are obtained, that is to say, this is to avoid excessive efficiency loss, and to control hot spot risk and improve the conditions of manufacturing capability.

Further, in some embodiments, in order to cause the efficiency loss of the solar cell 100 to be not greater than 0.4%, the value N may be less than or equal to 3.45 cm/cm$^2$. Therefore, the efficiency loss may be further reduced, and at the same time, the solar cell 100 may also have the high reverse leakage characteristic.

Preferably, in some embodiments, in order to cause the efficiency loss of the solar cell 100 to be not greater than 0.3%, the value N may be preferably less than or equal to 2.59 cm/cm$^2$. Therefore, the efficiency loss may be further reduced, and at the same time, the solar cell 100 may also have the high reverse leakage characteristic.

In some embodiments, when the reverse voltages applied to the two ends of the solar cell 100 are 9 V, the leakage current per unit length of the leakage combined contact structure 40 also meets the condition of greater than Impp/S/N. When the reverse voltages applied to the two ends of the solar cell 100 are 6 V, the leakage current per unit length of the leakage combined contact structure 40 also meets the condition of greater than Impp/S/N.

In some embodiments, in the cell assembly 200, the cell assembly 200 includes a plurality of cell strings. The cell string includes a plurality of solar cells 100 in series, and a bypass diode is in parallel connection with two ends of the cell string.

The reverse bias of two ends of the solar cell 100 shadowed are <D*Voc*(M-1\)+L.

The reverse bias are voltages of the two ends of the shadowed solar cell 100 when the solar cell 100 is shadowed and the leakage current of the shadowed solar cell 100 reaches the maximum power point current; and Voc is an open circuit voltage of the solar cell 100, M is the number of the solar cells 100 in the cell string that is in parallel connection with the bypass diode, D is a constant less than 1, and L is a starting voltage of the bypass diode.

Therefore, when the bypass diode is disposed in the cell assembly 200 and the solar cell 100 is shadowed, the reverse bias when the solar cell 100 operates at the maximum power point current meets the above condition, the reverse bias is smaller than a reverse bias in conventional solutions, and the heating power is smaller, thereby achieving the purpose of controlling the hot spot risk.

Specifically, in this embodiment, the magnitude of $V_{Impp}$ is determined by the leakage capability of the solar cell 100 having the high reverse leakage characteristic, and if the reverse leakage capability is stronger, $V_{Impp}$ is smaller, that is, if the reverse leakage capability is stronger, the reverse bias of the two ends of the solar cell are smaller when the leakage current of the shadowed solar cell reaches the maximum power point current. That is to say, by using such technical solutions, compared to traditional conventional solutions, when the solar cell is shadowed, the reverse voltages of the two ends are smaller than reverse voltages of two ends of a solar cell in the conventional technical solutions, such that the heating power is reduced, the hot spot risk caused by the defects is reduced, and at the same time, the control requirement for the leakage current during production can also be reduced.

Definitely, in some embodiments, in the cell assembly 200, the reverse bias of the two ends of the solar cell 100 shadowed are <D*Voc*(P-1).

The reverse bias are voltages of the two ends of the shadowed solar cell 100 when the solar cell 100 is shadowed and the leakage current of the shadowed solar cell 100 reaches the maximum power point current; and Voc is the open circuit voltage of the solar cell 100, P is the number of the solar cells 100 that are in series connection with the shadowed solar cell 100, and D is a constant less than 1.

That is to say, in this embodiment, regardless of whether the cell string is parallelly connected to the bypass diode, the reverse bias of the two ends of the shadowed solar cell 100 both meet such conditions. In this way, the heating power of the shadowed solar cell 100 is smaller, thereby achieving the purpose of controlling the hot spot risk.

Further, in the above embodiments, a value range of the constant D is preferably 0.1-0.5. Therefore, the reverse bias of the two ends of the shadowed solar cell 100 are reduced compared to voltages in the conventional technical solutions, such that the heating power may be greatly reduced. That is to say, by improving the leakage capability of the solar cell 100, the shadowed solar cell 100 can reach the maximum power point current at a smaller reverse bias.

In some embodiments, in the cell assembly 200, when the solar cell 100 is shadowed, the heating power of the single leakage combined contact structure 40 is less than 8.85 W.

Therefore, when the solar cell 100 is shadowed, the heating power of each leakage combined contact structure 40 is less than 8.85 W, such that the decomposition and carbonization of a packaging material of the assembly due to excessive heating power may be prevented from fire risks.

In this embodiment, the heating power of the single leakage combined contact structure 40 may be preferably less than 6.23 W.

Specifically, as shown in Fig. 10, experimental validation yields simultaneously that, in the solar cell 100, when the spacing between leakage points is large, the heating power needs to be controlled to be less than 8.85 W, and when the spacing between the leakage points is small, the heating power needs to be controlled to be less than 6.23 W. Therefore, the heating power of the single leakage combined contact structure 40 is required to be at least less than 8.85 W, preferably less than 6.23 W, such that the packaging material of the assembly may be prevented from being decomposed and carbonized, and the fire risk is reduced.

In some embodiments, in the cell assembly 200, the number S of the leakage combined contact structures 40 in the solar cell meets the following condition.

$$S > (Impp * V_{Impp})/8.85 \text{ W}$$

Impp is a maximum power point current of the solar cell 100, $V_{Impp}$ is reverse bias of two ends of the shadowed solar cell 100 when the solar cell 100 is shadowed and a leakage current of the shadowed solar cell 100 reaches a maximum power point current, and S is a positive integer.

Therefore, in order to meet the requirement that the heating power of each leakage combined contact structure 40 does not exceed at least 8.85 W, more leakage combined contact structures 40 on the solar cell 100 may be designed. In this way, when the maximum power point current and the reverse bias of the two ends of the solar cell are constant, the heating amount may be shared by designing a sufficiently large number of the leakage combined contact structures 40, thereby excessive heating amount of a single point is prevented from causing the decomposition and carbonization of the packaging material.

Specifically, Table 2 shows a minimum requirement relationship between the number of the leakage combined contact structures 40 and total heating power.

Table 2

| Cell area (cm$^2$) | V$_{Impp}$ (V) (Impp is 6.54) | Total heating power (W) | The number of the leakage combined contact structures required when the heating power of the single leakage combined contact structure is <8.85 W | Relationship between number and heating power |
|---|---|---|---|---|
| 165.62 | 1 | 6.54 | 1.00 | The number of the leakage combined contact structures required at least is >(Impp* (V$_{Impp}$)/8.85 W |
| | 2 | 13.08 | 2.00 | |
| | 3 | 19.62 | 3.00 | |
| | 4 | 26.16 | 4.00 | |
| | 5 | 32.7 | 4.00 | |
| | 6 | 39.24 | 5.00 | |
| | 7 | 45.78 | 6.00 | |
| | 8 | 52.32 | 6.00 | |
| | 9 | 58.86 | 7.00 | |
| | 10 | 65.4 | 8.00 | |
| | 11 | 71.94 | 9.00 | |
| | 12 | 78.48 | 9.00 | |
| | 13 | 85.02 | 10.00 | |
| | 14 | 91.56 | 11.00 | |
| | 15 | 98.1 | 12.00 | |
| | 16 | 104.64 | 12.00 | |
| | 17 | 111.18 | 13.00 | |

From Table 2 above, it may be seen that, in order to achieve an anti-hot spot effect of contact, a minimum number of the leakage combined contact structures 40 in point distribution on the solar cell should meet a requirement of being greater than (Impp*(V@Impp)/8.85 W.

In some embodiments, S may be preferably greater than (Impp*V$_{Impp}$)/6.23 W. In this way, the decomposition and carbonization of the packaging material may also be avoided even though the spacing between the adjacent leakage combined contact structures is small.

Definitely, in a possible embodiment, the solar cell 100 may also be designed such that when the solar cell 100 is shadowed, a sum of the heating amounts of all the leakage combined contact structures 40 is less than 8.85 W. In this way, regardless of the number of the leakage combined contact structures 40, the sum of the heating amounts of all the leakage combined contact structures 40 is not greater than 8.85 W, such that resistance to hot spot fire risk may be realized to the greatest extent.

Referring to Fig. 3 and Fig. 7, in some embodiments, in the solar cell 100, spacing between two adjacent leakage combined contact structures 40 is greater than or equal to 4 cm.

Therefore, the leakage combined contact structures 40 may be prevented from being distributed too dense, leading to a poor heat dissipation effect, thus causing an increase in temperature due to excessively concentrated heat generated when being shadowed.

Specifically, it is easily understood that, in the solar cell 100, factors affecting final temperatures during heat balance are as follows: 1) heating power; 2) material heat capacity; 3) thermal conductivity; and 4) heat dissipation effect.

At present, the material matching of a crystalline silicon cell is relatively fixed. Under certain material heat capacity, thermal conductivity, and heat dissipation, the requirement that the single-point heating power is <8.85 W is obtained through experiments. However, if there are a plurality of heating points, the distribution has a significant impact on the heat dissipation effect. From Fig. 10, it may be learned that, when the heating points are far away, the single-point heating power is required to be <8.85 W, and when the heating points are relatively close, the power is required to be reduced to <6.23 W, this is because the heating points that are too close reduce surrounding temperature gradients, resulting in a poor heat dissipation effect.

Based on this, through research, the inventor of the present disclosure found that, when nearest spacing between the heating points is 4 cm, it may be seen that the surrounding temperature gradients have started to show significant effects, and thus, the heat dissipation effect is reduced. Therefore, in order to ensure that the hot spot temperature is effectively controlled, the spacing between the heating points needs to be controlled, such that a plurality of heat dissipation points need to be uniformly distributed at intervals on the silicon wafer 10 as much as possible. Based on this, through research, the inventor of the present disclosure found that, a better heat dissipation effect may be achieved by controlling the spacing between the two adjacent leakage combined contact structures 40 to be not less than 4 cm, thereby avoiding overheating due to excessively concentrated heat.

It may be understood that, "the spacing between two adjacent leakage combined contact structures 40 being greater than or equal to 4 cm" means that within a range of 4 cm around one leakage combined contact structure 40, no other leakage combined contact structures 40 exist in either direction.

In some embodiments, when the solar cell 100 is shadowed, in the solar cell 100, and within any 4 cm*4 cm square range, the leakage current $I_{leakage}$ of the solar cell 100 meets the following condition:

$$I_{leakage} < 8.85 \text{ W/V}_{Impp}$$

$I_{leakage}$ is a sum of leakage currents of all the leakage combined contact structures 40 within the 4 cm*4 cm square range, and $V_{Impp}$ is reverse bias of two ends of the shadowed solar cell 100 when the solar cell 100 is shadowed and a leakage current of the shadowed solar cell 100 reaches a maximum power point current.

Therefore, by limiting the sum of the leakage currents of all the leakage combined contact structures 40 within the $4 \times 4$ square range, in one aspect, the heat may be prevented from excessively concentrating in a region to lead to an increase in the temperature; and in another aspect, the total heating amount within the $4 \times 4$ square range may be limited to be at least less than 8.85 W, such that the decomposition and carbonization of a packaging material due to a temperature generated by heating being greater than 160 °C are avoided.

Further, in some embodiments, in order to further reduce the temperature generated by heating to be less than 130 °C so as to further reduce the fire risk, when the solar cell 100 is shadowed, in the solar cell 100, and within any 4 cm*4 cm square range, the leakage current $I_{leakage}$ of the solar cell 100 may meet the following condition: $I_{leakage} < 4.54 \text{ W/V}_{Impp}$.

Further, in some embodiments, in order to further reduce the temperature generated by heating to be less than 110 °C so as to further reduce the fire risk, when the solar cell 100 is shadowed, in the solar cell 100, and within any 4 cm*4 cm square range, the leakage current $I_{leakage}$ of the solar cell 100 meets the following condition: $I_{leakage} < 2.26 \text{ W/V}_{Impp}$.

In the description of the specification, descriptions of the terms "some embodiments," "exemplary embodiment", "example," "specific example," or "some examples", mean that specific features, structures, materials, or characteristics described with reference to the implementations or examples are included in at least one implementation or example of the present disclosure. In this specification, schematic representations of the above terms do not necessarily refer to the same embodiment or example. In addition, the described particular features, structures, materials or characteristics may be combined in any suitable manner in any one or more embodiments or examples.

Furthermore, the above are merely preferred embodiments of the present disclosure, but are not intended to limit the present disclosure. Any modification, equivalent replacement, improvement, or the like made within the spirit and principle of the present disclosure should fall within the protection scope of the present disclosure.

**Claims**

1. A solar cell, comprising:

   a silicon wafer;
   A first doped layer disposed on the silicon wafer in a stacked manner; and
   A second doped layer disposed on the silicon wafer in a stacked manner, wherein the second doped layer has a polarity opposite to the first doped layer, the second doped layer is in a combined contact with the first doped layer in a preset position to form a leakage combined contact structure, and in a case that a reverse voltage applied to two ends of the solar cell is 17 V or less than 17 V, a leakage current per unit length of the leakage combinedcombined contact structure is greater than Impp/S/N, wherein Impp is a maximum power point current of the solar cell, S is an area of the solar cell, N is a length of the leakage combined contact structure per unit area in the solar cell, and N is less than or equal to 4.32 cm/cm$^2$.

2. The solar cell according to claim 1, wherein the N is less than or equal to 3.45 cm/cm$^2$.

3. The solar cell according to claim 1, wherein the N is less than or equal to 2.59 cm/cm$^2$.

4. The solar cell according to claim 1, wherein in a case that the reverse voltage applied to the two ends of the solar cell is 9 V, the leakage current per unit length of the leakage combined contact structure is greater than Impp/S/N.

5. The solar cell according to claim 1, wherein in a case that the reverse voltage applied to the two ends of the solar cell is 6 V, the leakage current per unit length of the leakage combined contact structure is greater than Impp/S/N.

6. The solar cell according to claim 1, being a double-sided solar cell, wherein the silicon wafer has a first surface and a second surface, which are opposite to each other; the first doped layer is disposed on the first surface in a stacked manner; the second doped layer is disposed on the second surface in a stacked manner; the second doped layer and the first doped layer form a combined contact in a preset position on an edge of the silicon wafer, so as to form the leakage combined contact structure.

7. The solar cell according to claim 1, being a back-contact solar cell, wherein the silicon wafer has a front side and a back side, which are opposite to each other; a plurality of first doped layers and a plurality of second doped layers are disposed on the back side in a stacked manner; the plurality of first doped layers and the plurality of second doped layers are alternately arranged in sequence at intervals; there is a gap region between each of the plurality of first doped layer and each of the plurality of second doped layer; in a preset position of the gap region, the first doped layer and the second doped layer are in a combined contact to form the leakage combined contact structure.

8. A cell assembly, comprising a plurality of solar cells according to any one of claims 1 to 7.

9. **The** cell assembly according to claim 8, comprising a plurality of cell strings, wherein the cell string comprises the plurality of solar cells in series connection, and a bypass diode is in parallel connection with two ends of each of the plurality of cell strings;

   reverse bias of two ends of the solar cell shadowed is <D*Voc*(M-1)+L;
   the reverse bias is the voltage of the two ends of the shadowed solar cell in a case that the solar cell is shadowed and a leakage current of the shadowed solar cell reaches a maximum power point current; and Voc is an open circuit voltage of the solar cell, M is the number of the solar cells in the cell string that is in parallel connection with the bypass diode, D is a constant less than 1, and L is a starting voltage of the bypass diode.

10. The cell assembly according to claim 8, comprising a plurality of cell strings, wherein the cell string comprises the plurality of solar cells in series connection;

    reverse bias of two ends of the solar cell shadowed is <D*Voc*(P-1);
    the reverse bias is the voltage of the two ends of the shadowed solar cell in a case that the solar cell is shadowed and a leakage current of the shadowed solar cell reaches a maximum power point current; and Voc is an open circuit voltage of the solar cell, P is the number of the solar cells that are in series connection with the shadowed solar cell, and D is a constant less than 1.

11. The cell assembly according to claim 9 or 10, wherein a value range of the D is 0.1-0.5.

12. The cell assembly according to claim 8, wherein in a case that the solar cell is shadowed, heating power of the single leakage combined contact structure in the solar cell is less than 8.85 W.

13. The cell assembly according to claim 8, wherein the number S of the leakage combined contact structures in the solar cell meets the following condition:

$$S>(Impp*V_{Impp})/8.85\ W;$$

Impp is a maximum power point current of the solar cell, $V_{Impp}$ is reverse bias of two ends of the shadowed solar cell in a case that the solar cell is shadowed and a leakage current of the shadowed solar cell reaches a maximum power point current, and S is a positive integer.

14. The cell assembly according to claim 8, wherein in a case that the solar cell is shadowed, in the solar cell, and within any 4 cm*4 cm square range, the leakage current $I_{leakage}$ of the solar cell meets the following condition:

$$I_{leakage} < 8.85 \ W/V_{Impp};$$

$I_{leakage}$ is a sum of leakage currents of all the leakage combined contact structures within the 4 cm*4 cm square range, and $V_{Impp}$ is reverse bias of two ends of the shadowed solar cell in a case that the solar cell is shadowed and a leakage current of the shadowed solar cell reaches a maximum power point current.

15. The cell assembly according to claim 14, wherein in a case that the solar cell is shadowed, in the solar cell, and within any 4 cm*4 cm square range, the leakage current $I_{leakage}$ of the solar cell meets the following condition:

$$I_{leakage} < 4.54 \ W/V_{Impp};$$

$I_{leakage}$ is the sum of leakage currents of all the leakage combined contact structures within the square range, and $V_{Impp}$ is the reverse bias of the two ends of the shadowed solar cell in a case that the solar cell is shadowed and the leakage current of the shadowed solar cell reaches the maximum power point current.

16. The cell assembly according to claim 15, wherein in a case that the solar cell is shadowed, in the solar cell, and within any 4 cm*4 cm square range, the leakage current $I_{leakage}$ of the solar cell meets the following condition:

$$I_{leakage} < 2.26 \ W/V_{Impp};$$

$I_{leakage}$ is the sum of leakage currents of all the leakage combined contact structures within the square range, and $V_{Impp}$ is the reverse bias of the two ends of the shadowed solar cell in a case that the solar cell is shadowed and the leakage current of the shadowed solar cell reaches the maximum power point current.

17. The cell assembly according to claim 8, wherein in the solar cell, spacing between two adjacent leakage combined contact structures is greater than or equal to 4 cm.

18. A photovoltaic system, comprising the cell assembly according to any one of 8 to 17.

Fig. 1

1000

Photovoltaic
system

Cell
assembly

200

Fig. 2

200

Cell assembly

Solar cell | Solar cell · · · · · ·

100    100

Fig. 3

Fig. 4

Fig. 5

Fig. 6

Fig. 7

Fig. 8

Fig. 9

Fig. 10

Fig. 11

## INTERNATIONAL SEARCH REPORT

| International application No. |
| --- |
| **PCT/CN2024/112899** |

**A. CLASSIFICATION OF SUBJECT MATTER**

H01L31/0224(2006.01)i;  H01L31/0216(2014.01)i;  H01L31/18(2006.01)i

According to International Patent Classification (IPC) or to both national classification and IPC

**B. FIELDS SEARCHED**

Minimum documentation searched (classification system followed by classification symbols)

IPC:  H01L31/-

Documentation searched other than minimum documentation to the extent that such documents are included in the fields searched

Electronic data base consulted during the international search (name of data base and, where practicable, search terms used)

CNTXT, ENTXTC, CNKI, ISI_WEB OF SCIENCE: 电池, 硅片, 衬底, 掺杂, 第一, 第二, 接触, 漏电流, 热斑, battery, doped, first, second, Substrate, leakage, contact, hot spot

**C. DOCUMENTS CONSIDERED TO BE RELEVANT**

| Category* | Citation of document, with indication, where appropriate, of the relevant passages | Relevant to claim No. |
| --- | --- | --- |
| PX | CN 117976743 A (ZHEJIANG AIKO SOLAR ENERGY TECHNOLOGY CO., LTD.) 03 May 2024 (2024-05-03) <br> claims 1-18 | 1-18 |
| A | CN 117334760 A (TRINA SOLAR CO., LTD.) 02 January 2024 (2024-01-02) <br> description, embodiment 1, and paragraph [0096], and figures 9-13 | 1-18 |
| A | CN 116995130 A (ZHEJIANG AIKO SOLAR ENERGY TECHNOLOGY CO., LTD. et al.) 03 November 2023 (2023-11-03) <br> entire description | 1-18 |
| A | CN 219626672 U (ZHEJIANG AIKO SOLAR ENERGY TECHNOLOGY CO., LTD. et al.) 01 September 2023 (2023-09-01) <br> entire description | 1-18 |
| A | CN 219738973 U (ZHEJIANG AIKO SOLAR ENERGY TECHNOLOGY CO., LTD. et al.) 22 September 2023 (2023-09-22) <br> entire description | 1-18 |
| A | US 5609694 A (SHARP K.K.) 11 March 1997 (1997-03-11) <br> entire description | 1-18 |

☐ Further documents are listed in the continuation of Box C.  ☑ See patent family annex.

| \* | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **06 December 2024** | **23 December 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/112899**

| Patent document cited in search report | | | Publication date (day/month/year) | Patent family member(s) | | | Publication date (day/month/year) |
|---|---|---|---|---|---|---|---|
| CN | 117976743 | A | 03 May 2024 | None | | | |
| CN | 117334760 | A | 02 January 2024 | None | | | |
| CN | 116995130 | A | 03 November 2023 | None | | | |
| CN | 219626672 | U | 01 September 2023 | None | | | |
| CN | 219738973 | U | 22 September 2023 | None | | | |
| US | 5609694 | A | 11 March 1997 | JPH | 07297429 | A | 10 November 1995 |
| | | | | JP | 3032422 | B2 | 17 April 2000 |
| | | | | DE | 69535071 | D1 | 03 August 2006 |
| | | | | DE | 69535071 | T2 | 04 January 2007 |
| | | | | EP | 0680099 | A2 | 02 November 1995 |
| | | | | EP | 0680099 | A3 | 20 August 1997 |
| | | | | EP | 0680099 | B1 | 21 June 2006 |

Form PCT/ISA/210 (patent family annex) (July 2022)